# DEMANDE DE BREVET EUROPEEN

(11) **EP 1 235 225 A2**
(43) Date de publication de la demande: **28.08.2002**
(21) Numéro de dépôt: 02290278.7
(22) Date de dépôt: 05.02.2002
(51) Int. Cl.: G11C 8/04

(54) **Procédé et dispositif de lecture séquentielle d'une mémoire avec saut d'adresse**

(30) Priorité: 23.02.2001 FR 0102501
(71) Demandeur: STMicroelectronics S.A., 92120 Montrouge (FR)
(72) Inventeur: Bahout, Yvon, 92593 Levallois-Perret (FR)
(74) Mandataire: Ballot, Paul

(57) **Abrégé**

L'invention concerne un procédé de lecture séquentielle d'une mémoire (10) mettant en oeuvre un compteur d'adresse incrémental (12), caractérisé en ce qu'un saut d'adresse comprend les étapes suivantes consistant à :
(a) détecter un signal de saut d'adresse,
(b) incrémenter le compteur d'adresse incrémental (12),
(c) lire le contenu (28) de la mémoire (10) à l'adresse incrémentée,
(d) transférer (34, 32) le contenu lu à l'adresse incrémentée dans le compteur d'adresse incrémental, et
(e) lire le contenu (28) de la mémoire (10) à l'adresse contenue dans le compteur d'adresse incrémental (12).

## Description

L'invention concerne les mémoires à accès série et à lecture séquentielle et, plus particulièrement dans de telles mémoires, un procédé et un dispositif pour réaliser un saut d'adresse.

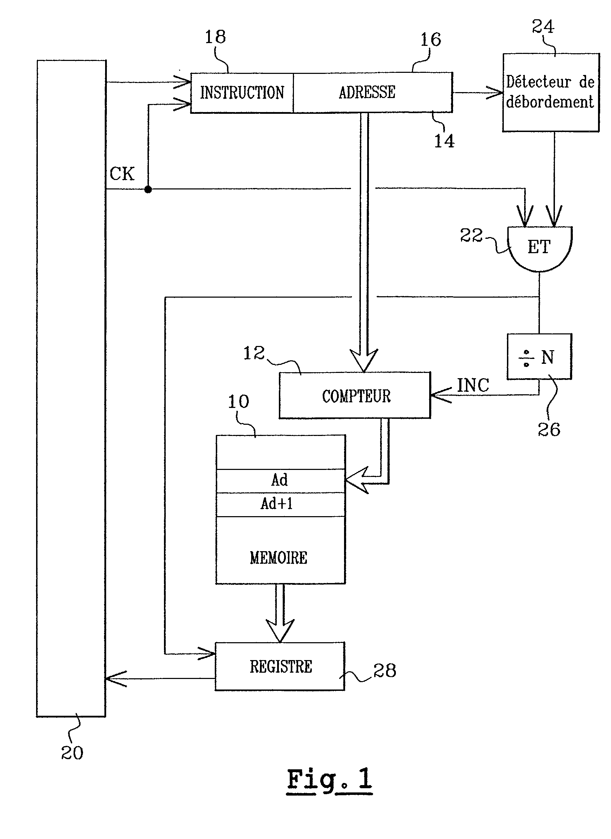

Un dispositif de lecture séquentielle d'une mémoire selon l'art antérieur sera décrit en relation avec le schéma fonctionnel de la figure 1. Une mémoire 10, qui comprend des cellules de mémoire et des circuits d'adressage de ses cellules, est lue séquentiellement d'une adresse à la suivante grâce à un compteur 12 dont la valeur, correspondant à l'adresse de la cellule en cours de lecture, est incrémentée d'une unité à chaque apparition d'un signal INC.

L'adresse de début du comptage est donnée par un registre à décalage 14 qui contient, outre l'adresse de début dans une partie 16, le code de l'instruction dans une partie 18.

Le registre à décalage 14 est chargé par un microcontrôleur 20 extérieur à la mémoire 10 au rythme d'impulsions d'horloge CK qui sont appliquées au registre à décalage 14 et à une porte logique ET 22.

Un détecteur de débordement 24 du registre à décalage 14 fournit un signal d'ouverture de la porte 22 dès que les décalages successifs aboutissent à commencer à vider le contenu du registre. Par suite de cette ouverture, les impulsions d'horloge CK sont appliquées à un circuit diviseur 26 par N, N étant le nombre de bits d'un mot contenu à une adresse de la mémoire, par exemple N= 8, ou 16 ou 24.

Le contenu du compteur 12 est donc incrémenté d'une unité chaque fois que le diviseur a compté N impulsions d'horloge CK et sélectionne ainsi l'adresse suivante.

Les chiffres binaires d'un mot à l'adresse sélectionnée par le compteur 12 sont lus l'un après l'autre et sont enregistrés dans un registre à décalage de sortie 28 au rythme des signaux d'horloge CK. Ils sont ensuite transmis au microcontrôleur 20.

La description ci-dessus montre que la mémoire 10 est lue séquentiellement ligne après ligne par suite de l'incrémentation du compteur 12 par le signal INC apparaissant tous les N signaux d'horloge CK, chaque signal d'horloge correspondant à la lecture d'un chiffre du mot binaire contenu à l'adresse Ad donnée par le compteur 12.

Lorsque la lecture doit être réalisée avec un saut à une nouvelle adresse, le microcontrôleur doit envoyer un nouveau message qui contient une instruction de saut et une nouvelle adresse. Il est donc nécessaire au microcontrôleur 20 d'envoyer un message complet, ce qui prend du temps et diminue la vitesse moyenne des opérations d'un programme, ceci d'autant plus que le programme comprend de nombreux sauts d'adresse.

Aussi, le but de l'invention est de mettre en oeuvre un procédé et de réaliser un dispositif de lecture séquentielle d'une mémoire dans lesquels les sauts d'adresse sont très rapides.

Ce but est atteint en transmettant à la mémoire, non pas un message complet mais un signal de commande, c'est-à-dire sans adresse, ce signal de commande étant interprété par la mémoire comme indiquant que la nouvelle adresse à utiliser est la valeur du mot contenu à l'adresse suivante.

L'invention concerne un procédé de lecture séquentielle d'une mémoire mettant en oeuvre un compteur d'adresse incrémental, caractérisé en ce que un saut d'adresse comprend les étapes suivantes consistant à :
(a) détecter un signal de saut d'adresse,
(b) incrémenter le compteur d'adresse incrémental,
(c) lire le contenu de la mémoire à l'adresse incrémentée,
(d) transférer le contenu lu à l'adresse incrémentée dans le compteur d'adresse incrémental, et
(e) lire le contenu de la mémoire à l'adresse contenue dans le compteur d'adresse incrémental.

L'opération (a) peut consister à décoder un code d'instruction de saut.

L'incrémentation du compteur d'adresse 12 peut être d'une unité ou plus.

L'invention concerne également un dispositif de lecture séquentielle d'une mémoire comprenant un registre d'entrée contenant un code d'instruction et un code d'adresse de la mémoire, un compteur d'adresse incrémental de la mémoire qui reçoit le code d'adresse du registre d'entrée, un registre de sortie de la mémoire qui enregistre les signaux lus à l'adresse indiquée par le compteur d'adresse incrémental,
caractérisé en ce qu'il comprend, en outre,
- un circuit de détection d'une instruction de saut d'adresse pour fournir un signal d'incrémentation du compteur d'adresse incrémental, et
- des moyens pour transférer le contenu lu à l'adresse incrémentée dans le compteur d'adresse incrémental.

D'autres caractéristiques et avantages de la présentation apparaîtront à la lecture de la description suivante d'un exemple particulier de réalisation, ladite description étant faite en relation avec les dessins joints dans lesquels :
- la figure 1 est un schéma simplifié d'un dispositif de lecture séquentielle d'une mémoire selon l'art antérieur,
- la figure 2 est un schéma simplifié d'un dispositif de lecture séquentielle d'une mémoire selon la présente invention.

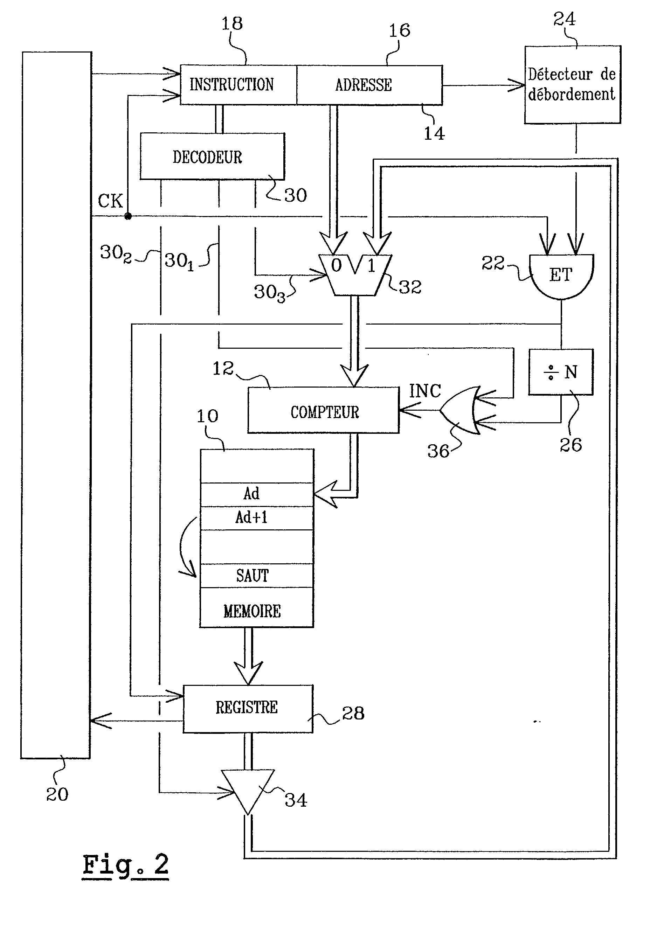

Le schéma de la figure 1 correspond à un dispositif de l'art antérieur qui a été décrit dans le préambule des présentes. Le schéma de la figure 2, correspondant à l'invention, reprend les éléments du schéma de la figure 1 qui portent la même référence mais d'autres éléments de manière à réaliser le dispositif selon l'invention.

Ces éléments communs aux deux dispositifs de lecture séquentielle ne seront pas décrits à nouveau.

Les éléments qui sont ajoutés sont :
- un circuit décodeur d'instruction de saut 30 dont les bornes d'entrée sont connectées aux bornes de sortie du registre à décalage 14 correspondant au code d'instruction et qui fournit sur ses trois bornes de sortie 30₁, 30₂ et 30₃ trois signaux décalés dans le temps correspondant au décodage du saut d'adresse,
- un premier signal dit d'incrémentation d'adresse sur la borne 30₁ qui est appliqué sur une des deux bornes d'entrée d'une porte logique OU 36 dont l'autre borne d'entrée est connectée à la borne de sortie du circuit diviseur 26,
- un deuxième signal dit de transfert sur la borne 30₂ qui est appliqué à une borne d'entrée d'une porte électronique 34 dont les autres bornes d'entrée sont connectées aux bornes de sortie parallèles du registre à décalage de sortie 28,
- un troisième signal dit de multiplexage sur la borne 30₃ qui est appliqué à une borne d'entrée de commande d'un circuit multiplexeur d'adresse 32,
- le circuit multiplexeur d'adresse 32 dont la borne d'entrée de commande est connectée à la borne de sortie 30₃ du circuit décodeur 30 et qui aiguille vers le compteur d'adresse 12 soit l'adresse contenue dans le registre à décalage 14, soit une adresse lue dans la mémoire.

Le fonctionnement du dispositif selon l'invention est alors le suivant :
- en lecture séquentielle, le fonctionnement est celui du dispositif de l'art antérieur,
- en cas de saut d'adresse, les éléments ajoutés conduisent au fonctionnement suivant :
   Le décodage de l'instruction par le circuit décodeur 30 fournit un premier signal d'incrémentation sur la borne de sortie 30₁ qui, via la porte logique 36, incrémente d'une unité le compteur 12 de sorte que l'adresse suivante (Ad + 1) de la mémoire est sélectionnée.
   Lorsque le mot à l'adresse suivante est enregistré dans le registre de décalage de sortie, il est transféré vers le multiplexeur 32 via la porte électronique 34 qui est ouverte par le signal de transfert sur la borne de sortie 30₂ du circuit décodeur 30.
   Ce mot transféré, qui correspond à l'adresse suivante du programme, est enregistré dans le compteur 12 via le circuit multiplexeur 32 commandé par le signal de multiplexage fourni sur la borne de sortie 30₃ du circuit décodeur 30.
   La lecture séquentielle peut alors recommencer à partir de cette nouvelle adresse ou il peut y avoir un autre saut d'adresse initié par un décodage d'une nouvelle instruction de saut d'adresse.
   L'invention peut être mise en oeuvre, non pas à l'aide d'une instruction de saut d'adresse qui est décodée comme indiqué ci-dessus, ce qui prend au moins le temps de transfert des chiffres du code d'instruction, mais par un signal particulier fourni par le microcontrôleur 20 et qui est appliqué directement aux circuits 32, 34 et 36 avec des retards appropriés.

## Revendications

1. Procédé de lecture séquentielle d'une mémoire (10) mettant en oeuvre un compteur d'adresse incrémental (12), **caractérisé en ce qu'**un saut d'adresse comprend les étapes suivantes consistant à :
(a) détecter un signal de saut d'adresse,
(b) incrémenter le compteur d'adresse incrémental (12),
(c) lire le contenu (28) de la mémoire (10) à l'adresse incrémentée,
(d) transférer (34, 32) le contenu lu à l'adresse incrémentée dans le compteur d'adresse incrémental (12), et
(e) lire le contenu (28) de la mémoire (10) à l'adresse contenue dans le compteur d'adresse incrémental (12).

2. Procédé selon la revendication 1, **caractérisé en ce que** l'étape (a) consiste à décoder un code d'instruction.

3. Procédé selon la revendication 1 ou 2, **caractérisé en ce que** l'étape (b) consiste à incrémenter d'au moins une unité le compteur d'adresse incrémental.

4. Dispositif de lecture séquentielle d'une mémoire (10) comprenant un registre d'entrée (14) contenant un code d'instruction et un code d'adresse de la mémoire (10), un compteur d'adresse incrémental de la mémoire (10) qui reçoit le code d'adresse du registre d'entrée (14), un registre de sortie (28) de la mémoire (10) qui enregistre les signaux lus à l'adresse indiquée par le compteur d'adresse incrémental (12),
**caractérisé en ce qu'**il comprend, en outre,
- un circuit de détection (30) d'une instruction de saut d'adresse pour fournir un signal d'incrémentation du compteur d'adresse incrémental (12), et
- des moyens (34, 32) pour transférer le contenu lu à l'adresse incrémentée dans le compteur d'adresse incrémental (12).

5. Dispositif selon la revendication 4, **caractérisé en ce que** le circuit de détection d'une instruction de saut d'adresse est un circuit décodeur.

6. Dispositif selon la revendication 4 ou 5,
**caractérisé en ce que** les moyens pour transférer le contenu lu à l'adresse incrémentée dans le compteur d'adresse incrémental comprennent :
- une porte logique (34) pour transférer en parallèle le contenu du registre de sortie (28) correspondant au contenu à l'adresse incrémentée, et
- un circuit multiplexeur (32) pour aiguiller vers le compteur d'adresse incrémental (12) soit le code d'adresse contenu dans le registre d'entrée (14), soit le code d'adresse contenu à l'adresse incrémentée.
